# EUROPEAN PATENT APPLICATION

(11) **EP 4 739 076 A1**
(43) Date of publication of application: **06.05.2026**
(21) Application number: 25211962.3
(22) Date of filing: 29.10.2025
(51) Int. Cl.: H10W 72/00, H10W 72/50

(54) **WIRE-BOND STRUCTURE FOR POWER PACKAGES TO REDUCE RDSON**

(30) Priority: 29.10.2024 NL 2038948
(71) Applicant: Nexperia B.V., 6534 AB Nijmegen (NL)
(72) Inventor: Zhong, Chenchao, Hong Kong (HK); Flauta, Randolph Estal, Hong Kong (HK); Fan, Haibo, Hong Kong (HK)
(74) Representative: Pjanovic, Ilija

(57) **Abstract**

A semiconductor device, a semiconductor package comprising such semiconductor device and a method of manufacturing such semiconductor package are presented. The semiconductor device comprises a die (202) and a leadframe (204). The semiconductor device further comprises a wire-bond interconnect structure comprising one or more pairs (208) of wires. Herein, a pair (208) of wires comprises two wires that are bonded together at one end at the die (202) and that are bonded together on the other end at the leadframe (204).

## Description

### Technical field

The present disclosure relates to a semiconductor device, a semiconductor package comprising such semiconductor device. More specifically, the present disclosure relates to wire-bonding in such semiconductor device.

### Background

Drain-to-Source On Resistance (Rdson), i.e., the resistance between the drain and source terminals when turned on, is a critical parameter in power packages, particularly in power Metal Oxide Silicon Field Effect Transistors (MOSFETs) and other power semiconductor devices. It plays a significant role in determining the performance, efficiency, and thermal behavior of these devices.

For example, in relation to power dissipation and efficiency, Rdson can directly affect the amount of power the device dissipates during operation. A lower Rdson reduces power loss, making the device more efficient, especially in high-current applications. In power packages like those used in power converters, motor drives, and switching regulators, minimizing Rdson maximizes efficiency and minimize energy loss.

In another example, in relation to thermal management, power devices generate heat due to power dissipation, and Rdson can be a major contributor to this. Lower Rdson results in lower power dissipation, which leads to reduced heat generation. This is important because excessive heat can degrade the performance, reliability, and lifespan of semiconductor devices. In power packages, optimizing Rdson helps minimize the need for additional cooling solutions like heatsinks or fans, reducing overall system cost and complexity.

In another example, in relation to switching performance, in applications involving switching, such as Direct Current (DC) to DC converters or inverters, Rdson can influence the overall switching speed and performance. Although Rdson primarily affects conduction losses (when the device is on), it indirectly impacts switching behavior by influencing the thermal profile and efficiency. Efficient thermal management achieved through lower Rdson helps maintain consistent performance during fast switching cycles, reducing the risk of thermal runaway or device failure.

In another example, in relation to size and compactness of power packages, a lower Rdson allows for smaller and more compact power packages. When devices generate less heat, they can be designed with smaller footprints without sacrificing performance. This can be crucial in modern applications where size, weight, and space are critical factors, such as in electric vehicles and portable electronics.

In another example, in relation to impact on system reliability, since Rdson can directly affect power dissipation and heat generation, it can also impact the long-term reliability of the power package. Excessive heat due to high Rdson can lead to thermal cycling failures due to stresses on the device and its packaging materials. Over time, this can cause failures like bond wire fatigue or solder joint cracking. By minimizing Rdson, manufacturers can improve the durability and reliability of power devices, ensuring they can withstand harsh operating conditions and prolonged use.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure presents an improved wire-bond structure for power semiconductor devices and power packages including such power semiconductor device to reduce Rdson. Furthermore, a method of manufacturing such improved wire-bond structure is presented.

According to an aspect of the present disclosure, a semiconductor device is presented. The semiconductor device may include a die and a leadframe. The semiconductor device may further include a wire-bond interconnect structure. The wire-bond interconnect structure may include one or more pairs of wires. A pair of wires includes two wires that are bonded together at one end at the die and that are bonded together on the other end at the leadframe.

In an embodiment, the pair of wires may include a first wire that is wedge bonded to the die at one end of the first wire and that is wedge bonded to the leadframe at the other end of the first wire.

In an embodiment, the pair of wires may further include a second wire that is ball bonded to the first wire at the die at one end of the second wire and that is stitch bonded to the first wire at the leadframe at the other end of the second wire.

In another embodiment, the pair of wires may further include a second wire that is stitch bonded to the first wire at the die at one end of the second wire and that is ball bonded to the first wire at the leadframe at the other end of the second wire.

In another embodiment, the pair of wires may further include a second wire that is wedge bonded to the first wire at the die at one end of the second wire and that is wedge bonded to the first wire at the leadframe at the other end of the second wire.

In an embodiment, the two wires of the pair of wires may have a same or similar thickness.

In an embodiment, the two wires of the pair of wires may have a same of similar thickness in a range of about 75µm to about 500µm, e.g., about 75µm.

In an embodiment, the two wires of the pair of wires may have different thicknesses.

In an embodiment, the first wire may have a thickness in a range of about 75µm to about 500µm. The second wire may have a thickness in a range of about 75µm to about 500µm. The thickness of the first wire may be different from the thickness of the second wire.

In an embodiment, the first wire may have a thickness in a range of about 75µm to about 500µm. The second wire may have a thickness in a range of about 16µm to about 75µm. The thickness of the first wire may be different from the thickness of the second wire.

In an embodiment, the semiconductor device may be a power semiconductor device, e.g., a power MOSFET.

According to an aspect of the present disclosure a semiconductor package is presented. The semiconductor package may include a semiconductor device having one or more of the above-described features.

In an embodiment, the semiconductor package may be a Micro Leadframe Package (MLPAK), e.g., an MLPAK56 package.

According to an aspect of the present disclosure, a method of manufacturing a semiconductor package is presented. The semiconductor device may have one or more of the above-described features. The method may include providing a die and a leadframe. The method may further include applying a first wire between the die and the leadframe by bonding the ends of the first wire to the die and the leadframe, respectively. The method may further include applying a second wire between the die and the leadframe by bonding the ends of the second wire to the ends of the first wire at the die and at the leadframe, respectively.

In an embodiment, the method may include wedge bonding the first wire to the die at one end of the first wire and wedge bonding the first wire to the leadframe at the other end of the first wire.

In an embodiment, the method may include ball bonding the second wire to the first wire at the die at one end of the first wire and stitch bonding the second wire to the first wire at the leadframe at the other end of the first wire.

In an embodiment, the method may include stitch bonding the second wire to the first wire at the die at one end of the first wire and ball bonding the second wire to the first wire at the leadframe at the other end of the first wire.

In an embodiment, the method may include wedge bonding the second wire to the first wire at the die at one end of the first wire and wedge bonding the second wire to the first wire at the leadframe at the other end of the first wire.

### Brief description of the Drawings

Embodiments of the present disclosure will now be described, by way of example only, with reference to the accompanying schematic drawings in which corresponding reference symbol indicate corresponding parts, in which:
Fig. 1A is a 3D representation of a known semiconductor package showing the wire-bonding;
Fig. 1B is a 2D representation of a part of Fig. 1A;
Fig. 2A is a 3D representation of an example semiconductor package showing an example embodiment of a wire-bond interconnect structure of the present disclosure;
Fig. 2B is a 2D representation of a part of Fig. 2A;
Fig. 3 shows an example embodiments of a pair of wires of a wire-bond interconnect structure of the present disclosure; and
Fig. 4 shows an example embodiment of manufacturing steps of a pair of wires of a wire-bond interconnect structure of the present disclosure.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

The solution of the present disclosure relates to wire-bonding in semiconductor packages, and in particular to a wire-bond structure for use in power semiconductor devices. **In** semiconductor packaging according to the present disclosure, bond wires may be thin metal wires, e.g., having a thickness of about 16µm to 75µm, and/or thick metal wires, e.g., having a thickness of about 75µm to 500µm, that connect a semiconductor die to the package or to other parts of the circuit. The solution of the present disclosure may use different methods for wire bonding, e.g., ball bonding and/or wedge bonding.

In a "normal" or typical ball bonding, which includes a ball bond at one end of the wire and a stitch bond at the other end of the wire, the wire is first heated to form a small ball (also known as a free-air ball) at one end of the wire, e.g., using a flame or electronic discharge. The ball is then pressed onto, e.g., the die pad using a capillary tool to create the first bond (ball bond). The wire may then be looped and attached to the leadframe or substrate to form the second bond (stitch bond).

In wedge bonding, which includes a wedge bond at both ends of the wire, the wire is clamped and positioned under a wedge tool wherein pressure and ultrasonic power are applied to melt the wire to form the bond. The wire's first and second bonds are bonded directly to, e.g., the die or the leadframe, using a wedge tool. The wire is positioned at an angle and pressed onto, e.g., the bond pad on the die to form the first bond (first wedge bond). The wire may then be looped and bonded to the substrate or leadframe (second wedge bond).

In the following, where a bonding is described to a die or to a leadframe, this bonding may include a pad for bonding the wire to the die or a bare or plated metal surface such as a leadframe.

The present disclosure presents a novel wire-bond interconnect structure, which includes overlayed wire-bond pairs, with each pair including two wires that are bonded together to a die on one end and bonded together to a leadframe on the other end. The wire-bond interconnect structure of the present disclosure can reduce the wire-bond footprint significantly - it has been found that the wire-bond footprint can be reduced by 50% or more - allowing, e.g., the use of thicker and shorter wires. Moreover, it has been found that this structure can reduce Rdson significantly, e.g., by 65% or more. The reduced footprint area also allows for more wires to be added, possibly further reducing Rdson.

Other advantages of the wire-bond interconnect structure of the present disclosure include a reduction in the number of ball bond points, in an example by half, a shorter total wire length, e.g., 34% shorter in Micro Leadframe Packages (MLPAK) such as MLPAK56 packages, and enablement of using, e.g., 75µm wires instead of 50µm wires typically used in known power packages.

Aspects of the wire-bond interconnect structure of the present disclosure and the above-described advantages will be further detailed in the following.

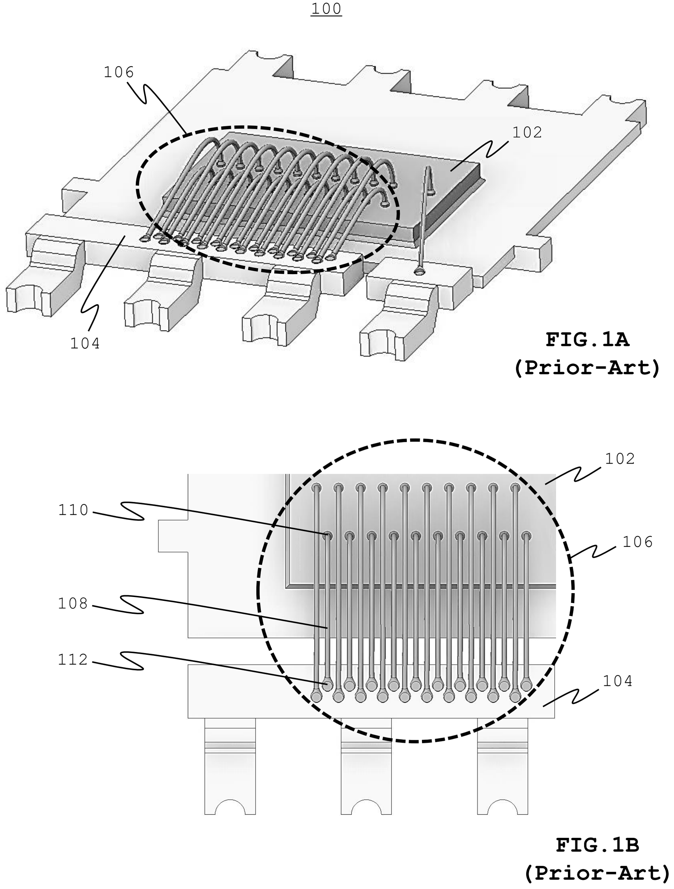

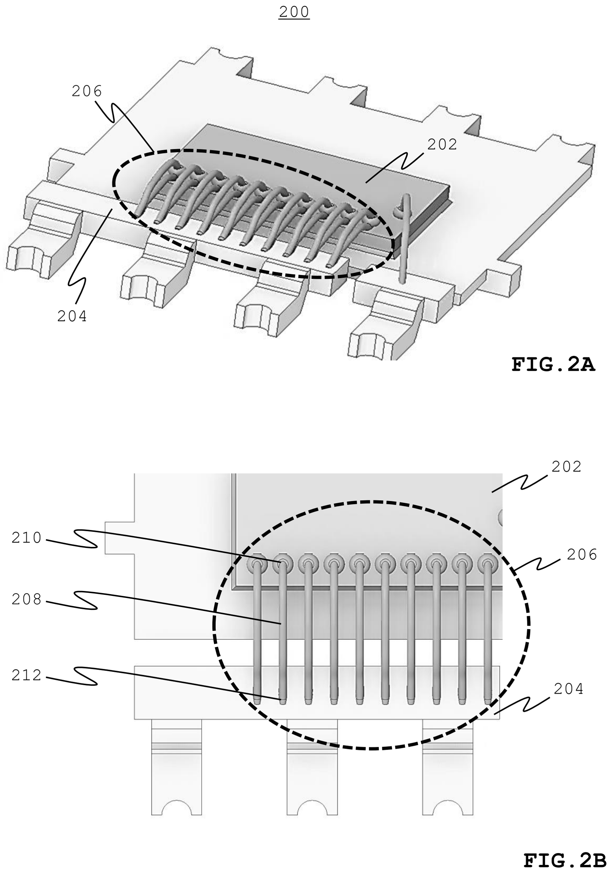

Fig. 1A and Fig. 2A are 3D representations of the inside of example semiconductor packages, focusing on the main components relevant to the present disclosure. Fig. 1B and Fig. 2B are 2D top-view representations of a part of Fig. 1A and Fig. 1B, respectively. Fig. 1A and Fig. 2A are presented to illustrate the improvement in the number of bond points, total wire length and required footprint on the die when using the solution of an example embodiment of the present disclosure (Fig. 2A) compared to a known solution (Fig. 1A).

In Fig. 1A, an example of a known MLPAK56 package 100 is shown, focusing on a die 102, a leadframe 104 and bond wires 106 connecting the die 102 with the leadframe 104 within the package 100. In this example, the bond wires 106 include twenty individual 50µm wires with twenty bond points on the die 102 for connecting the wires to the die 102. In this example, the total wire length is 39.1mm.

Fig. 1B shows a detail of Fig. 1A, showing the twenty individual wires 108 of the bond wires 106. Also shown are the twenty ball bond points 110 on the die 102 and twenty stitch bonds 112 on the leadframe 104, used in this example for connecting the wires 108 between the die 102 and the leadframe 104.

In Fig. 2A, an example of an MLPAK56 package 200 is shown, focusing on a die 202, a leadframe 204 and an example embodiment of a wire-bond interconnect structure of the present disclosure within the package 200. In this example, the wire-bond interconnect structure 206 includes twenty 75µm wires with only ten ball bond points on the die 202. The twenty wires are arranged as ten pairs of overlayed wires, wherein the ends of two wires in a pair are connected and no electrical connection exists between the wires of a pair in between the ends. **In** this example, the total wire length is 25.9mm.

Fig. 2B shows a detail of Fig. 2A, showing the ten pairs of overlayed wires 208 of the wire-bond interconnect structure 206. Also shown are the ten ball bond points 210 on the die 202 and stitch bonds 212 on the lead frame 204, used in this example for connecting the pairs of overlayed wires 208 between the die 202 and the leadframe 204.

The wire-bond interconnect structure 206 thus enables a significant improvement over the prior art bond wires 106. I.e., the wire thickness may be increased, e.g., from 50µm to 75µm (an increase of 50%), the number of ball bond points on the die may be reduced, e.g., from twenty to ten (a reduction of 50%), and the total wire length may be reduced, e.g., from 39.1mm to 25.9mm (34% shorter). Advantageously, the wire-bond interconnect structure 206 allows Rdson to be reduced from, e.g., 0.827 mOhm (die 102 not included) in the example of Fig. 1 to 0.288 mOhm (die 202 not included) in the example of Fig. 2, i.e., in this example a reduction of 65%.

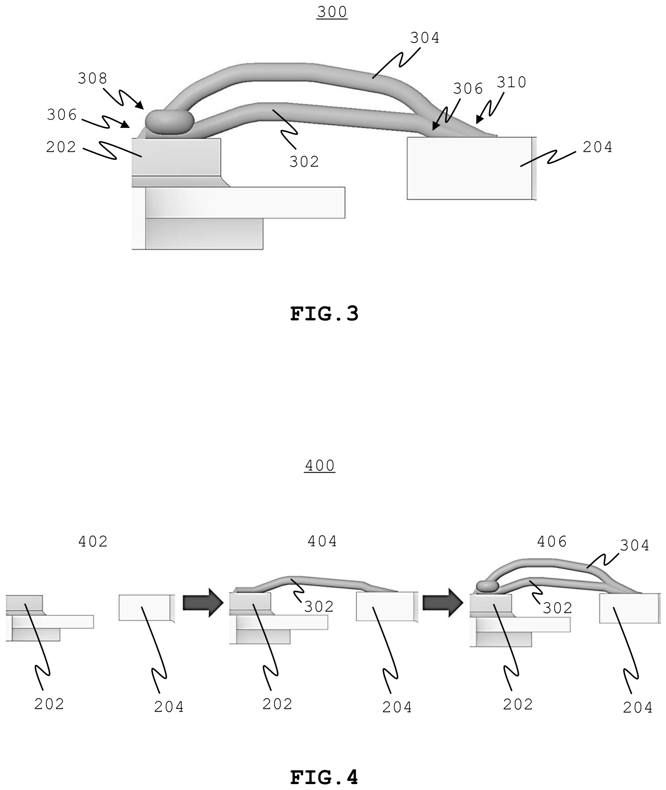

A pair of overlayed wires in a wire-bond interconnect structure, such as the pair of overlayed wires 208 in the wire-bond interconnect structure 206, may be arranged in various manners. An example embodiment is shown in Fig. 3. Other embodiments will be described below.

In the example embodiment of Fig. 3, a pair of overlayed wires 300 is shown, which may be similar or identical to one, more or all of the pairs of overlayed wires 208 in the example of Fig. 2A and Fig. 2B. At one end, a first wire 302 may be wedge bonded 306 to the die 202. At the other end, the first wire 302 may be wedge bonded 306 to the leadframe 204. At one end, a second wire 304 may be ball bonded 308 to the wedge bond 306 of the first wire 302 at the die 202. At the other end, the second wire 304 may be stitch bonded 310 with the first wire 302 at the leadframe 204.

In another example embodiment, not shown in the drawings, the second wire 304 may be applied the other way around, i.e., with one end being ball bonded 308 to the wedge bond 306 of the first wire 302 at the leadframe 204 and the other end being stitch bonded 310 to the first wire 302 at the die 202.

In yet another embodiment, not shown in the drawings, the wires in a pair of wires may have both ends wedge bonded together at the die and wedge bonded together at the leadframe. I.e., both wires in the pair of wires are then wedge bonded at both ends.

In an embodiment, the two wires in a pair of wires, such as the wires shown in Fig. 3, have the same or similar thickness. In a non-limiting example, the thickness of the first wire and the thickness of the second wire are in a range of about 75µm to about 500µm and the same. In a non-limiting example, the thickness of the first wire 302 may be about 75µm and the thickness of the second wire 304 may be about 75µm.

In another embodiment, the two wires in a pair of wires, such as the wires shown in Fig. 3, have different thicknesses. In a non-limiting example, the thickness of the first wire 302 may be in a range of about 75µm to about 500µm (i.e., a thick wire) and the thickness of the second wire 304 may be in a similar range (i.e., also a thick wire). In another non-limiting example, the thickness of the first wire 302 may be in a range of about 75µm to about 500µm (i.e., a thick wire) and the thickness of the second wire 304 may be in a range of about 16µm to about 75µm (i.e., a thin wire).

A wire-bond interconnect structure 206, such as the wire-bond interconnect structure 206, typically comprises a plurality of identical pairs of wires, but may include pairs of wires having different configurations, e.g., having different wire thicknesses and/or different wire lengths.

Wires of a wire pair may be made of any suitable conductive material, such as copper (Cu), Aluminum (Al), Al-coated Cu, gold (Au), silver (Ag) or coated Ag wires. The two wires in the pair of wires may have different material combinations, e.g., Cu/Al, Au/Cu, Cu/Ag, Au/Ag, coated Cu/Cu, and etcetera, or any other suitable wire material.

Preferably, both wires in a pair of wires use a low loop height profile to minimize Rdson.

Fig. 4 shows an example sequence 400 of steps in manufacturing the example pair of wires 300 of Fig. 3. Reference numbers 202, 204, 302 and 304 correspond to the reference numbers used in Fig. 3. In step 402, a die 202 and a leadframe 204 are provided. In step 404, the first wire 302 is bonded to the die 202 and to the leadframe 204. In this example, both ends of the first wire 302 are wedge bonded to the die 202 and to the leadframe 204, respectively. In step 406, the second wire 304 is bonded to the first wire 302 at the die 202 and to the second wire 304 at the leadframe 204. In this example, the die 202 side of the second wire 304 is ball bonded to the first wire 302 at the die 202 and the leadframe 204 side of the second wire 304 is stitch bonded to the first wire 302 at the leadframe 204.

It will be understood that the other embodiments of pairs of wires not shown in the drawings and described above may be manufactured in a similar manner, mutatis mutandis.

Advantageously, the manufacturing process of a semiconductor package, such as shown in Fig. 2A, including a wire-bond interconnect structure according to the present disclosure can achieve a similar units per hour (UPH) rate compared to known solutions, such as shown in Fig. 1A. Herein , UPH indicates the number of units (e.g., semiconductor devices, chips, packages) that can be processed or produced in one hour by a specific machine, process, or production line.

The wire-bond interconnect structure of the of the present disclosure may be implemented on any wire bonded Metal Oxide Silicon (MOS) products.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A semiconductor device comprising a die (202) and a leadframe (204), and further comprising:
a wire-bond interconnect structure comprising one or more pairs (208) of wires,
wherein a pair (208, 300) of wires comprises two wires (302, 304) that are bonded together at one end at the die (202) and that are bonded together on the other end at the leadframe (204).

2. The semiconductor device according to claim 1,
wherein the pair (300) of wires comprises a first wire (302) that is wedge bonded (306) to the die (202) at one end of the first wire (302) and that is wedge bonded (306) to the leadframe (204) at the other end of the first wire (302).

3. The semiconductor device according to claim 2,
wherein the pair (300) of wires further comprises a second wire (304) that is ball bonded (308) to the first wire (302) at the die (202) at one end of the second wire (304) and that is stitch bonded (310) to the first wire (302) at the leadframe (204) at the other end of the second wire (304).

4. The semiconductor device according to claim 2,
wherein the pair (208) of wires further comprises a second wire that is stitch bonded to the first wire at the die (202) at one end of the second wire and that is ball bonded to the first wire at the leadframe (204) at the other end of the second wire.

5. The semiconductor device according to claim 2,
wherein the pair (208) of wires further comprises a second wire that is wedge bonded to the first wire at the die (202) at one end of the second wire and that is wedge bonded to the first wire at the leadframe (204) at the other end of the second wire.

6. The semiconductor device according to any one of the claims 1-5, wherein the two wires of the pair of wires have a same or similar thickness.

7. The semiconductor device according to claim 6, wherein the two wires of the pair of wires have a same of similar thickness in a range of about 75µm to about 500µm, preferably about 75µm.

8. The semiconductor device according to any one of the claims 1-5, wherein the two wires of the pair of wires have different thicknesses.

9. The semiconductor device according to claim 8, wherein the first wire (302) has a thickness in a range of about 75µm to about 500µm, wherein the second wire (304) has a thickness in a range of about 75µm to about 500µm, and wherein the thickness of the first wire (302) is different from the thickness of the second wire (304).

10. The semiconductor device according to claim 8, wherein the first wire (302) has a thickness in a range of about 75µm to about 500µm, wherein the second wire (304) has a thickness in a range of about 16µm to about 75µm, and wherein the thickness of the first wire (302) is different from the thickness of the second wire (304).

11. The semiconductor device according to any one of the preceding claims, wherein the semiconductor device is a power semiconductor device, preferably a power Metal Oxide Silicon Field Effect Transistor, power-MOSFET.

12. A semiconductor package comprising a semiconductor device according to any one of the claims 1-11.

13. The semiconductor package according to claim 12, wherein the semiconductor package is a Micro Leadframe Package, MLPAK, preferably an MLPAK56 package.

14. A method of manufacturing (400) a semiconductor package according to claim 12 or claim 13, the method comprising:
providing (402) a die (202) and a leadframe (204);
applying (404) a first wire (302) between the die (202) and the leadframe (204) by bonding the ends of the first wire (302) to the die (202) and the leadframe (204), respectively;
applying (406) a second wire (304) between the die (202) and the leadframe (204) by bonding the ends of the second wire (304) to the ends of the first wire (302) at the die (202) and at the leadframe (204), respectively.

15. The method according to claim 14, comprising:
wedge bonding (306) the first wire (302) to the die (202) at one end of the first wire (302) and wedge bonding (306) the first wire (302) to the leadframe (204) at the other end of the first wire (302); and
ball bonding (308) the second wire (304) to the first wire (302) at the die (202) at one end of the first wire (302) and stitch bonding (310) the second wire (304) to the first wire (302) at the leadframe (204) at the other end of the first wire (302), or
stitch bonding the second wire to the first wire at the die (202) at one end of the first wire and ball bonding the second wire to the first wire at the leadframe (204) at the other end of the first wire, or
wedge bonding the second wire to the first wire at the die (202) at one end of the first wire and wedge bonding the second wire to the first wire at the leadframe (204) at the other end of the first wire.
